# EUROPEAN PATENT SPECIFICATION

(11) **EP 0 725 449 B1**
(45) Date of publication and mention of the grant of the patent: **03.02.1999**
(21) Application number: 96200713.4
(22) Date of filing: 27.11.1991
(51) Int. Cl.: H01L 39/24

(54) **A method for fabricating a Josephson device**
Verfahren zur Herstellung einer Josephson-Vorrichtung
Procédé de fabrication d'un dispositif Josephson

(43) Date of publication of application: 07.08.1996
(62) Divisional of application: 91203113.5
(73) Proprietor: OSAKA GAS COMPANY LIMITED, Osaka-shi Osaka-fu (JP)
(72) Inventor: Tamura, Itsuro, Kawachinagano-shi, Osaka-fu (JP); Fujita, Satoshi, Osaka-shi, Osaka-fu (JP); Wada, Masao, Osaka-shi, Osaka-fu (JP)
(74) Representative: Smulders, Theodorus A.H.J., Ir.

(56) References cited:
- US-A- 4 414 738
- US-A- 4 454 522

## Description

The present invention relates to a method of producing a superconductive device of the type with a Josephson junction.

A superconductive quantum interference device including a superconductive ring that couples with one or two Josephson junctions, is used for manufacturing a magnetic field generated from a heart, eye ball, brain, and like organisms of a human body. Such device is mentioned a superconductive quantum interference device or SQUID.

The SQUID serves as a sensor for measuring such an extremely weak magnetic field as generated from organisms. However, production of the device including the Josephson junction is conducted with the use of a fine processing technique, and the performance as a sensor directly depends on an error of the shape of the device after the processing. Further, the superconductive material to be used is a material which will be oxidized over time while being used. When the superconductive material in use is oxidized, it affects the performance of the device as a sensor as much as deformation of the Josephson junction. Therefore, it is difficult to maintain the initial performance of the device as it is produced, over the time.

Conventionally, a surface portion of the Josephson junction is oxidized in advance to protect the Josephson junction from the atmosphere, whereby forming an oxide film on the surface portion. However, in the case where oxide is formed on the surface portion, oxygen progressively diffuses over time in a thin film layer of superconducting material, for example Nb. As a result, there exists the problem that the properties of the device change due to the reduced thickness of the Nb thin film.

It is known to cover the surface portion with synthetic resin material. In these prior arts, the thermal expansion coefficient of the synthetic resin material differs greatly from that of the superconducting material. Accordingly, upon being subjected to a thermal hesteresis from liquid helium temperature of 4.2 °K to ordinary temperature, minute cracks are caused in the synthetic resin material, whereby the SQUID is deteriorated.

In order to solve the foregoing problem and isolate the SQUID fromt he oxidized atmosphere, it can be considered to retain the SQUID in an atmosphere of inert gas, such as N₂. However, this is not practical because it is difficult to prevent leaks.

Further, in existing SQUIDs, it has been difficult to form a uniform thin film of about 100 to 200 Å.

In US-A-4 414 738 a method is disclosed for producing a SQUID with Josephson microbridges with the aid of a technique referred to as "shadow evaporation." With this technique thin films are deposited using slant evaporation angles, so that very thin and narrow microbridges are obtained.

In US-A-4 454 522 a method is disclosed for producing a SNS microbridge superconductive device in which discontinuous layers of superconductive material are deposited on a substrate, using a similar slant evaporation technique as in US-A-4 414 738.

In the references mentioned the problem of deterioration of a SQUID due to oxidation is not addressed.

It is an object of the present invention to provide a process for producing with a low defect rate a high sensitivity Josephson device with improved properties of its Josephson junction by reliably preventing oxidation and age deterioration of the superconducting layers of the device.

The method according to the invention as claimed in claim 1 comprises the steps of forming a surface step on or in a substrate, forming a first thin film layer of superconducting material on said substrate and said step and subsequently forming a second thin film layer of a superconducting material on said first thin film layer by means of an oblique deposition technique from one side of said surface step so that the deposition is locally interrupted by said surface step and depositing a third thin film layer of a superconducting material by means of an oblique deposition technique from the opposite side of said surface step, so as to form a partially exposed region of said first thin film layer not covered by said second and third thin film layers near said step, said partially exposed region defining said Josephson junction, if desired followed by forming a covering layer of ordinary conducting material over the partially exposed region and a neighbouring region thereof.

According to the invention, the thin film region consisting of superconducting material formed on the substrate is, for example, a part of the Josephson junction, and the covering layer consisting of ordinary conducting metal or semiconductor is formed on the thin film region and the neighbouring region thereof. This enables the thin film region to be isolated from the oxidizing atmosphere, and thereby preventing the oxidation of the thin film region. In addition, the covering layer is not to present deterioration such as cracks even upon being subjected to a thermal hysterises from very low temperature of liquid helium to ordinary temperature. Accordingly, the thin film region can be protected over a long period. The ordinary conducting metal constituting the covering layer is, for example, Cr or Ta. The semiconductor constituting the covering layer is, for example, Si.

Further, according to the invention, a layer consisting of ordinary conducting material is formed on the substrate, and a thin film region consisting of superconducting material is formed on the ordinary conducting material layer, whereby obtaining a Josephson junction. Accordingly, the thin film region is formed on a clean layer, thereby reliably attaining the characteristics of Josephson effect. Further, since the actual thickness of the thin film region can be made smaller due to the proximity effect, it is made possible to form a layer consisting of superconducting material, that is relatively thick. Therefore, such a thin film consisting of superconducting material can be easily produced.

Furthermore, according to the invention, a layer consisting of ordinary conducting material may be formed on the Josephson junction, whereby enabling the Josephson junction to be protected from the external atmosphere. In addition, the actual thickness of the Josephson junction can be controlled to be smaller due to the proximity effect.

The ordinary conducting material used for the layer formed on the substrate and the superconducting material used for the layer formed on the Josephson junction may be, for example, Cr or Ta, or may be conducting material having a lower critical temperature than the superconducting material constituting the Josephson junction. The superconducting material having a lower critical temperature than the superconducting material for the Josephson junction is also included in a concept of the ordinary conducting material.

In an embodiment of the method according to the invention, a recessed channel is formed in the substrate for example by the use of a dry etching technique, and a thin film region consisting of superconducting material is formed on the bottom of the recessed channel, whereby obtaining the Josephson junction. Accordingly, the thin film region is formed on the clean bottom of the recessed channel. Therefore, there can be produced a Josephson device having excellent characteristics of the Josephson effect.

Further, according to the invention, the thin film region realizing the Josephson junction is formed by depositing the superconducting material from oblique directions using the opposite side walls of the recessed channel, and thereby partially exposing the thin film already formed entirely over the bottom of the recessed channel to obtain the thin film region. In this way, the thin film region realizing the Josephson junction can be formed on the clean bottom of the recessed channel.

Since the recessed channel is formed in the substrate and the thin film is partially exposed to form the thin film region forming the Josephson junction by conducting the oblique deposition using the opposite side walls of the recessed channel, the production process of the invention can be simplified and the entire process can be carried out in the same vacuum. This causes the production of the Josephson device to be carried out further more easily, and contamination of the surface of the substrate including the bottom of the recessed channel can be prevented.

Also, according to the invention, a covering layer consisting of ordinary conducting metal or semiconductor may be formed on the thin film region consisting of superconducting material formed on the substrate and a neighbouring region thereof. This enables the thin film region to be prevented from oxidizing. In addition, the covering layer is not to deteriorate over time even upon being repeatedly subjected to a thermal hysteresis from very low temperature to ordinary temperature. In this way, the Josephson device can be realized whose characteristics are not to change over a long period.

Furthermore, according to the invention, due to the proximity effect of the layer consisting of ordinary conducting material formed on the substrate and the layer consisting of ordinary conducting material formed on the Josephson junction, the actual thickness of the Josephson junction can be made thinner. This makes the characteristics of the Josephson effect satisfactory, thereby enabling the Josephson junction to have higher sensitivity. Further, since the thin film region forming the Josephson junction may be relatively thick, the production can be carried out easily.

### Brief description of the drawings

Other and further objects, features, and advantages of the invention will be more explicit from the following detailed description taken with reference to the drawings wherein:
Fig. 1 is a sectional view of a first embodiment of a Josephson device made in accordance with the invention:
Figs. 2(1) to 2(6) are sectional views showing the production process according to the invention of the first embodiment shown in Fig. 1;
Fig. 3 is a graph showing temperature dependency of resistance of Si constituting a covering layer 9;
Fig. 4 is a sectional view of a second embodiment of a Josephson device made in accordance with the invention;
Figs. 5(1) to 5(8) are sectional views showing the production process according to the invention of the second embodiment shown in Fig. 4;
Fig. 6 is a graph showing I-V characteristics of a superconductive quantum interference device;
Fig. 7 is a graph showing relationship between the thickness d11 of a Josephson region 14a and the current I1, experimentally obtained;
Fig. 8 is a graph showing I-V characteristics when the sum of the thickness of the first, second, and fifth layers 11, 14, 19 is set to 200 Å, which graph is experimentally obtained;
Fig. 9 is a sectional view of a superconductive quantum interference device of a third embodiment made in accordance with the invention;
Figs. 10(1) and 10(5) are sectional views showing a production process according to the invention of the third embodiment shown in Fig. 9; and
Fig. 11 is a sectional view showing a superconductive quantum interference device for comparison purposes.

### Detailed description of the preferred embodiments

Now referring to the drawings, preferred embodiments of the invention are described below.

### (Embodiment 1)

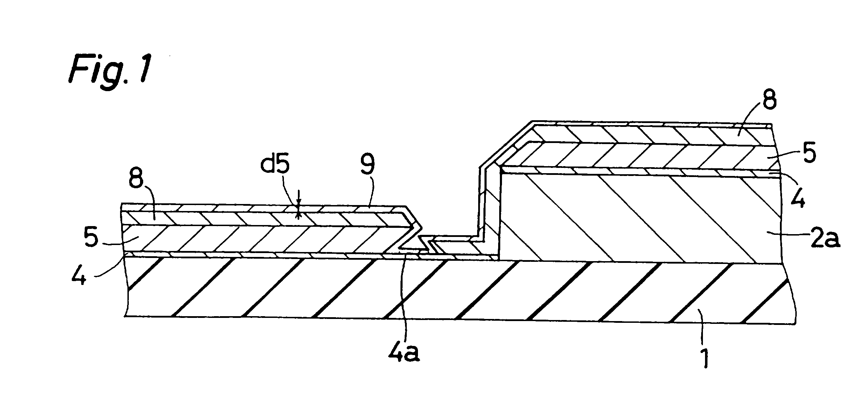

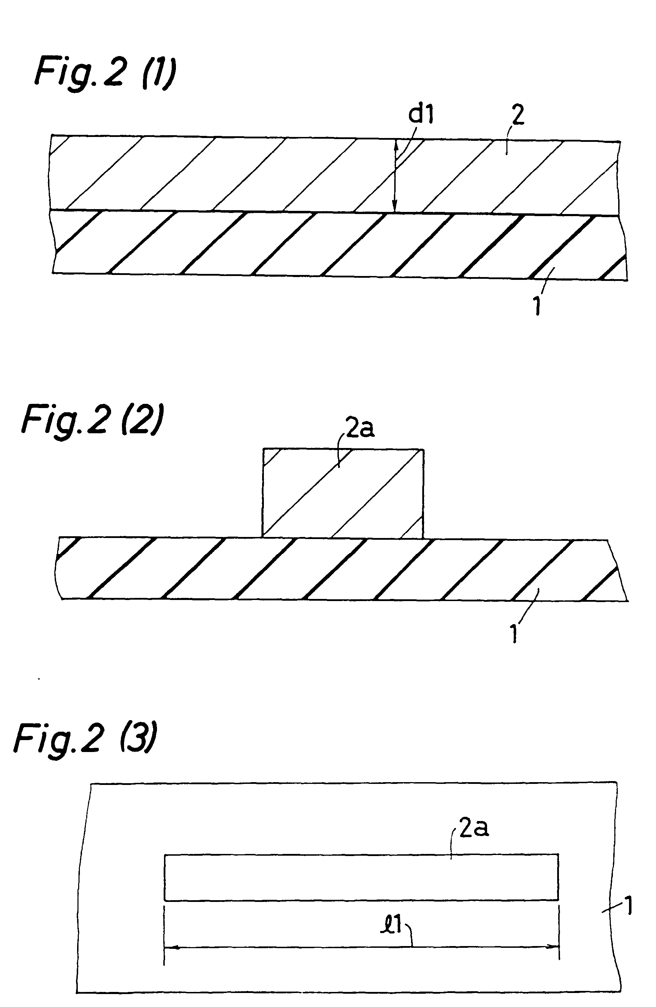

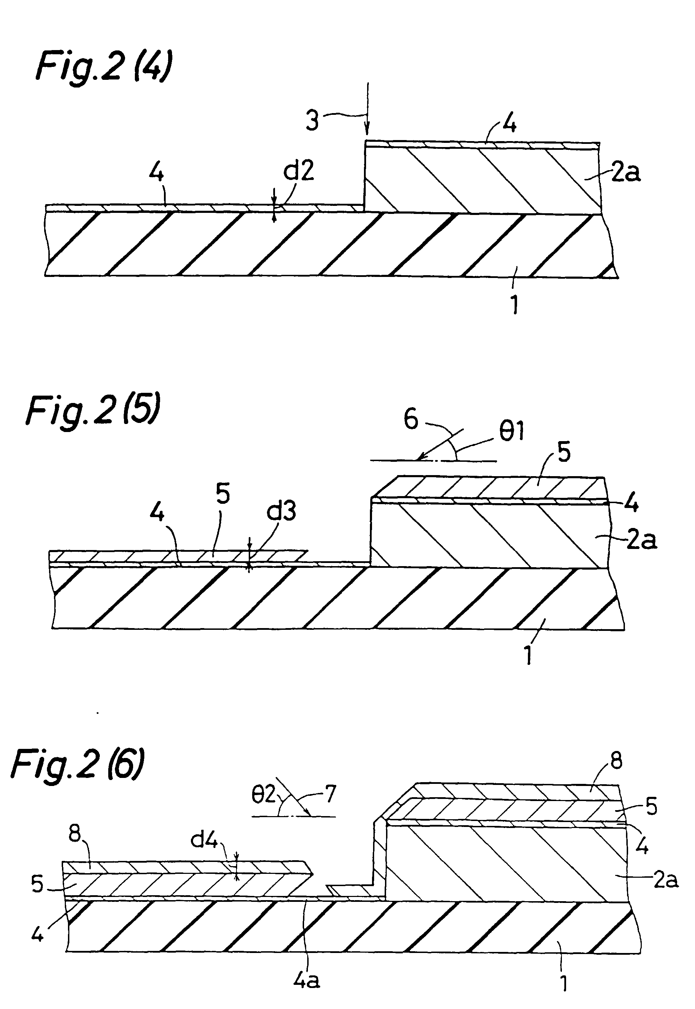

Fig. 1 is a sectional view partly showing a superconductive quantum interference device including a Josephson junction of a first embodiment made in accordance with the invention, and Figs. 2(1) to 2(6) are sectional views showing a production process according to the invention for producing a SQUID. With reference to these drawings, a substrate 1 consists of quartz, sapphire, Si which is a semiconductor, and like material. A layer 2 of a thin film is formed over an entire upper surface of the substrate 1 by deposition or sputter technique as shown in Fig. 2(1). Material for the thin film layer 2 may be, for example, Nb which provides superconducting material, or Cr or Ta which provides ordinary conducting material, or may be nonmetallic material. The thickness d1 of the thin film layer 2 is, for example, 100 to 200 Å (1Å = 0.1 nm).

The thin film layer 2 has a portion thereof selectively removed by the use of etching or the like, so that a long and narrow base 2a in the form of a step can be formed as shown in Fig. 2(2). Fig. 2(3) is a plan view showing the substrate 1 on which the base 2a is formed. The length L1 of the base 2a is, for example, 1 to 5 µm.

Next, as shown in Fig. 2(4), superconducting material such as Nb is deposited from a direction 3 perpendicular to the surface of the substrate 1, whereby forming a first layer 4 over the upper surfaces of the substrate 1 and the base 2a. The thickness d2 of the first layer 4 is, for example, 80 to 200 Å, preferably 80 to 150 Å, and more preferably 10 Å.

Thereafter, as shown in Fig. 2(5), superconducting material Nb is deposited from an arrow direction 6, whereby forming a second layer 5. The thickness d3 of the second layer 5 is, for example, 1000 Å. The depositing direction 6 makes an angle θ1 with respect to the surface of the substrate 1. The angle θ1 is, for example, between 25 and 70 degrees, and preferably between 25 and 50 degrees, and particles of superconducting material is supplied from the base 2a.

Subsequently, as shown in Fig. 2(6), superconducting material Nb is deposited from an arrow direction 7 on the second layer 5, whereby forming a third layer 8. The thickness d4 of the third layer 8 is, for example, 500 Å, and the sum of the thickness d3 and d4 is, for example, 200 to 2000 Å. In this way, a thin film region 4a is formed which is not covered by either the second layer 5 or the third layer 8. The Josephson junction is formed on the thin film region 4a.

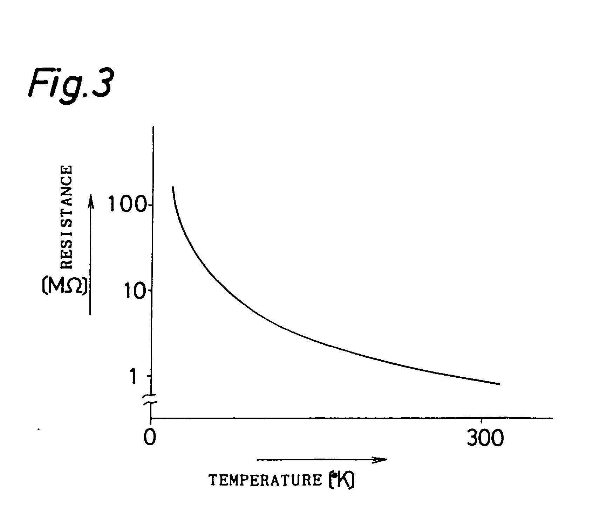

At the last stage, a covering layer 9 consisting of conducting or semiconducting material is formed on the third layer 8 and the thin film region 4a by the use of spatter technique as shown in Fig. 1. The conducting material constituting the covering layer 9 is, for example, metallic material such as Cr and Ta. On the other hand, the semiconducting material constituting the covering layer 9 is, for example, Si. Particularly, it is preferable that the covering layer 9 consists of Si since the temperature dependency of the resistance of Si has such characteristics that its electric resistance becomes substantially infinite at very low temperatures as shown in Fig. 3.

As shown in Figs. 2(5), 2(6), the second and third layers 5, 8 are formed by the use of an oblique deposition technique, and leave exposed the thin film region 4a on which the Josephson junction is formed. Thereafter, the covering layer 9 is formed, such that the thin film region 4a and the second and third layers 5, 8 are isolated by the covering layer 9 from the external atmosphere. The conducting or semiconducting material constituting covering layer 9 has a thermal expansion coefficient similar to that of the first, second, and third layers 4, 5, 8. Accordingly, even in the case where the SQUID is repeatedly subjected to a thermal hysteresis from a very low temperature of, for example, liquid helium to an ordinary temperature, there is no likelihood that minute cracks are caused in the covering layer 9.

According to an experiment conducted by the inventors it is confirmed that the property of the Josephson effect can be maintained over a long period when the thickness d2 of the first layer 4 is set to 80 Å, the sum of the thickness d3 and d4 of the second and third layers 5, 8 in the neighbourhood of the thin film region 4a having the Josephson junction formed thereon is set to 200 to 2000 Å, and the thickness d5 of the covering layer 9 consisting of Cr which provides an ordinary conducting material is set equal to 100 Å. On the contrary, an example of comparison wherein the covering layer 9 consists of niobium oxide and the thickness thereof is set to 100 Å exhibits a maintaining period of the characteristics of the Josephson effect shorter than that of the invention.

### (Embodiment 2)

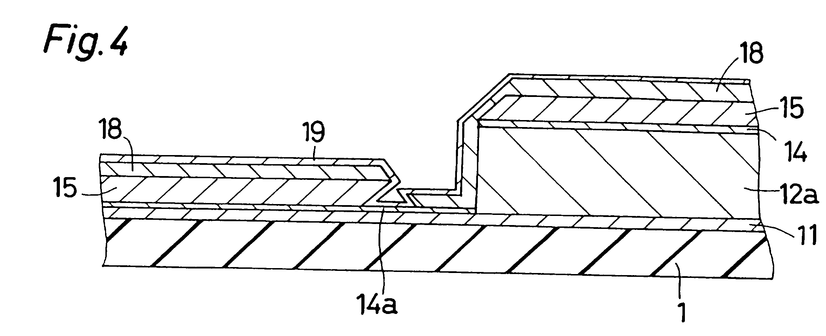

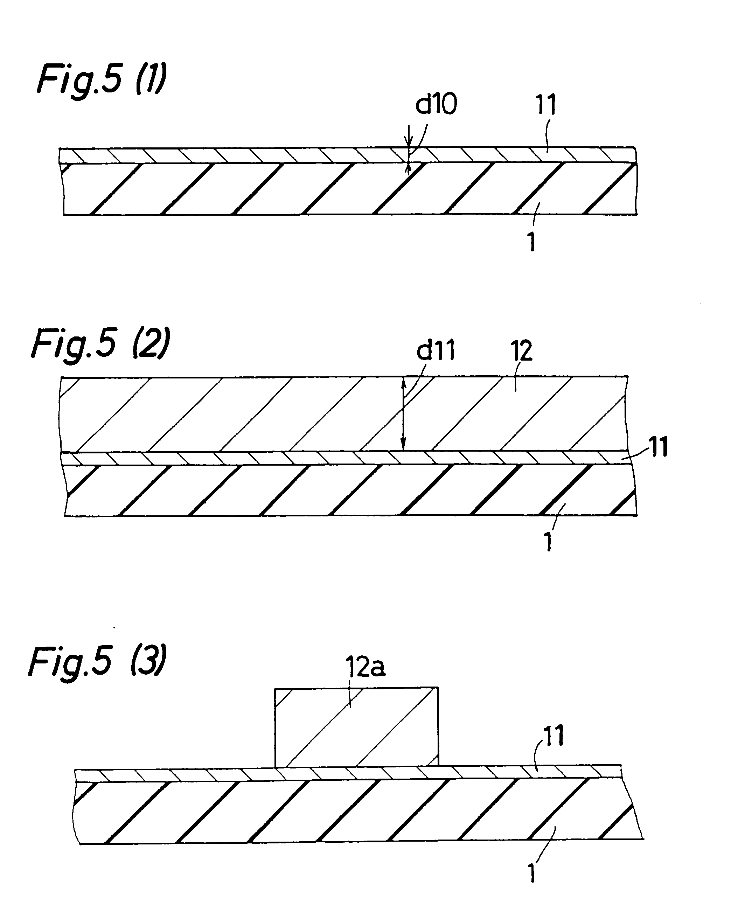

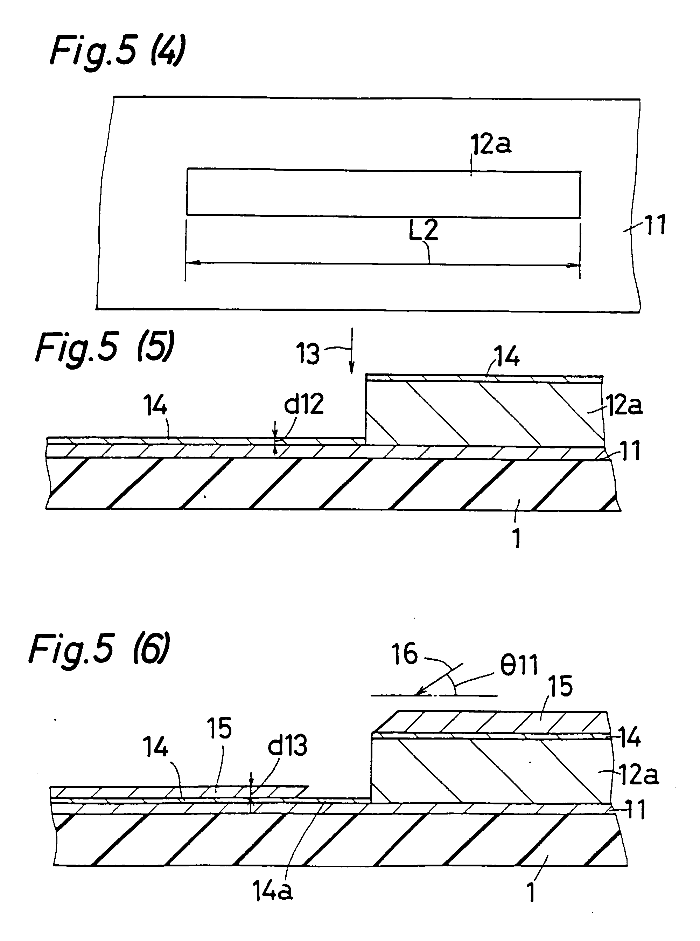

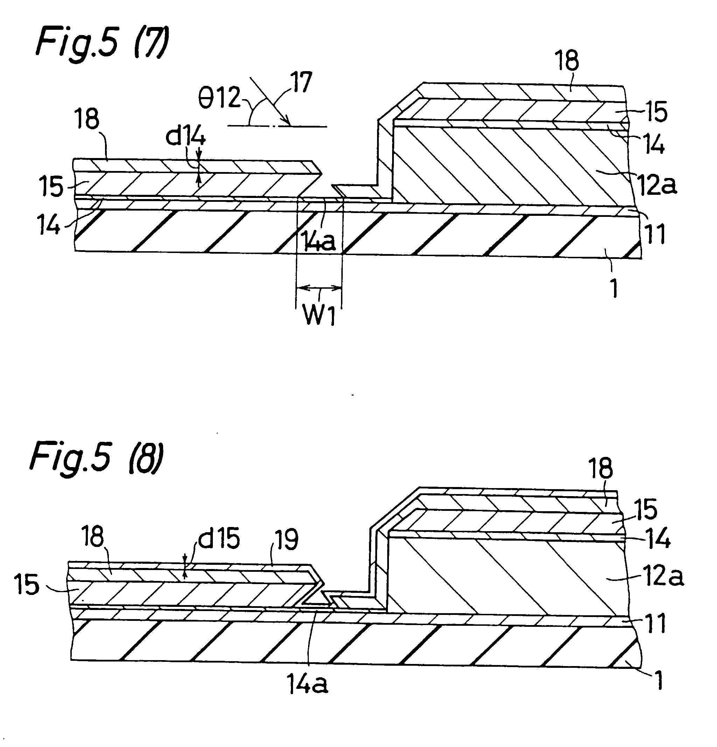

Fig. 4 is a partial sectional view of a superconductive quantum interference device of another embodiment made in accordance with the invention, and Figs. 5(1) to 5(8) are sectional views showing a production process according to the invention of the SQUID. A substrate 1 shown in Fig. 5(1) consists of quartz, sapphire, semiconductor such as Si, similarly to the substrate 1 shown in the first embodiment. A layer 11 consisting of ordinary conducting material is formed on the substrate 1. The ordinary conducting material constituting the layer 11 may be Cr or Ta. Alternatively, the layer 11 may consist of a superconducting material, such as Pb, having a low critical temperature lower than the critical temperature of a first layer 14 which forms a Josephson junction 14a; a thin film region to be described hereinafter. The thickness d10 of the layer 11 is, for example, 100 to 200 Å.

Subsequently, a thin layer 12 is formed entirely over the layer 11 as shown in Fig. 5(2). The thin layer 12 may consist of an ordinary conducting material, for example, a metallic material such as Cr and Ta. Alternatively, the thin layer 12 may consist of a nonmetallic material, or a superconducting material such as Nb. The thickness d11 of the thin layer 12 is, for example, 100 to 200 Å. After formation of the thin layer 12, the layer 12 is processed into the form of a long and narrow step by the use of etching or the like, whereby forming a base 12a as shown in Fig. 5(3). Fig. 5(4) is a plan view showing the layer 11 on which the base 12a is formed. The length L1 of the base 2a is, for example, 1 to 5 µm.

Thereafter, as shown in Fig. 5(5), a first layer 14 is formed by deposition in an arrow direction 13. The arrow direction 13 is perpendicular to the surface of the substrate 1, i.e., the layer 11. The first layer 14 consists of a superconducting material, for example, Nb. The thickness d12 of the first layer 14 is, for example, 300 to 500 Å, and may be relatively large.

Subsequently, as shown in Fig. 5(6), a second layer 15 is formed by deposition from an arrow direction 16. The second layer 15 consists of a superconducting material Nb. The angle 011 made by the arrow direction 16 with respect to the surface of the first layer 14 is, for example, between 25 and 70 degrees, and preferably between 25 and 50 degrees. The thickness d13 of the second layer 15 is, for example, 1000 Å.

As shown in Fig. 5(7), a third layer 18 is formed by deposition from an arrow direction 17. The third layer 18 consists of a superconducting material Nb, and the thickness d14 thereof is, for example, 500 Å. The sum of the thickness d13 and d14 is selected to be 200 to 2000 Å. The angle θ₂ made by the arrow direction 17 with respect to the surface of the first layer 14 is between 25 to 70 degrees, and preferably between 25 and 50 degrees. In this way, as shown in Figs. 5(6) and 5(7), the second and third layers 15, 18 are formed by the oblique deposition technique, from the directions 16, 17 from opposing sides, whereby the first layer 14 is partially exposed, forming a thin film region 14a. As a consequence, the Josephson junction can be obtained.

At the last stage, as shown in Fig. 5(8), a covering layer 19 is formed entirely over the surfaces of the Josephson junction 14a, the second and third layers 15, 18 by the use of the sputter technique. The thickness d15 of the layer 19 is, for example, 100 to 200 Å, and the layer 19 consists of material similar to the layer 11. More specifically, the layer 19 consists of Cr, Ta, or other ordinary conducting material, or superconducting material such as Pd having a low critical temperature lower than the critical temperature of the superconducting material constituting the first layer 14. In this way, there can be obtained a configuration shown in Fig. 5(8), i.e., a configuration shown in Fig. 4.

By conducting the oblique deposition from the two directions 16, 17 shown respectively in Figs. 5(6) and 5(7), it is possible to fabricate the Josephson junction 14a with high accuracy, so that the width W1 thereof (see Fig. 5(7)) can be set to, for example, 1 µm. Further, as shown in Figs. 5(3) and 5(4), the Josephson junction 14a having a length equal to the length L2 of the base 12a can be fabricated with high accuracy. In this way, the Josephson junction 14a can be fabricated by controlling the width W1 and the length L2 thereof with high accuracy in a simple production process. Further, the width W1 of the Josephson junction 14a can be set to a desired value by changing the angles θ11, θ12 of the arrow directions 16, 17 with respect to the surface of the first layer 14 in the oblique deposition technique. More specifically, in the oblique deposition technique, the angles θ11, θ12 made by the arrow directions 16, 17 can be changed easily in a desired manner, and therefore adjustment of an optimum shape of the SQUID can be performed easily. In other words, the oblique deposition technique is excellent in controllability for forming the Josephson junction 14a of the SQUID with accurate length L2 and width W1, thereby improving the fabricating thereof.

The Josephson junction 14a is of a sandwich structure comprising three layers 11, 14, 19. The invention has an excellent advantage that the oblique deposition technique can be applied to the Josephson device having such a structure. Specifically, this Josephson device provides a construction suitable for drawing advantageous features from the oblique deposition technique.

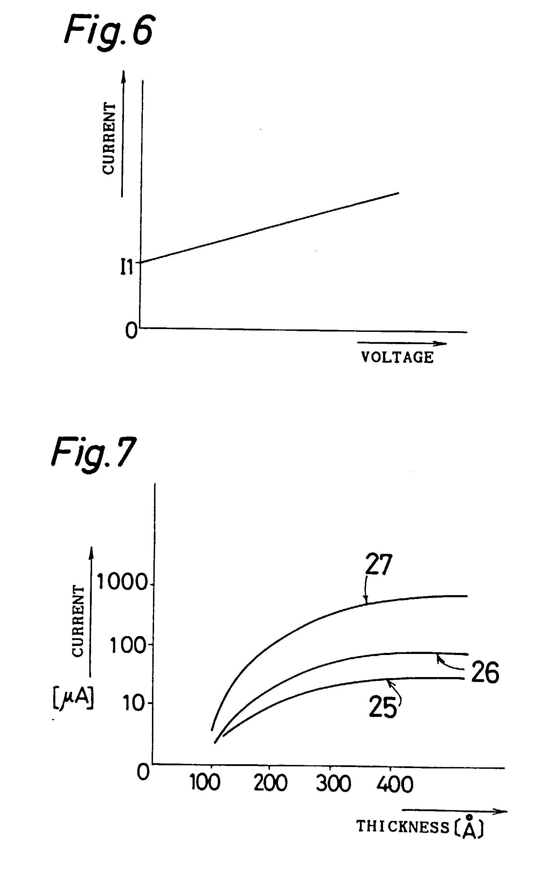

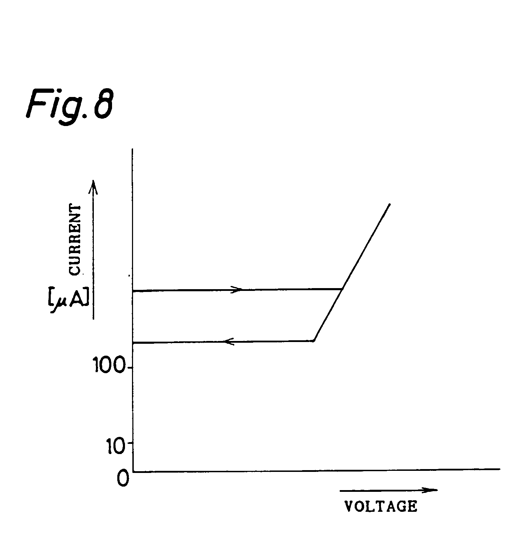

Fig. 6 is a graph showing the I-V characteristics of the superconductive quantum interference device shown in Figs. 4 and 5. In order to make smaller the maximum current obtainable in a superconductive state, i.e. the critical current I1, it is required to make the Josephson junction 14a thin. However, the SQUID is more subject to a bad influence depending on a stained state thereof when the thickness thereof is made thinner. Moreover, it is very difficult to form such a thin first layer 14. In the foregoing embodiment, the first layer 14 is formed relatively thin, and sandwiched between the layers 11, 19. Accordingly, the Josephson junction 14a looks substantially thick due to the proximity effect, thereby enabling the critical current I1 to decrease.

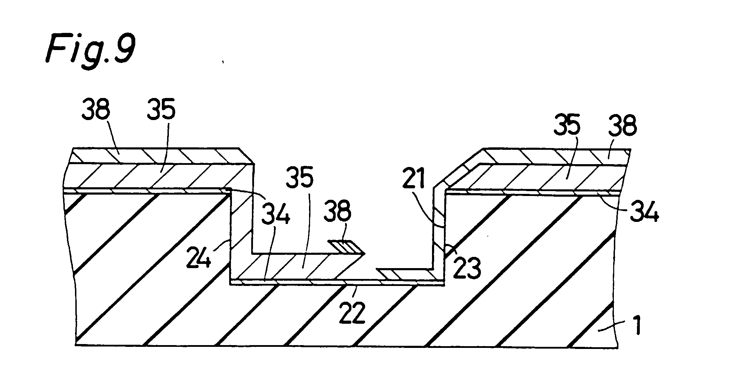

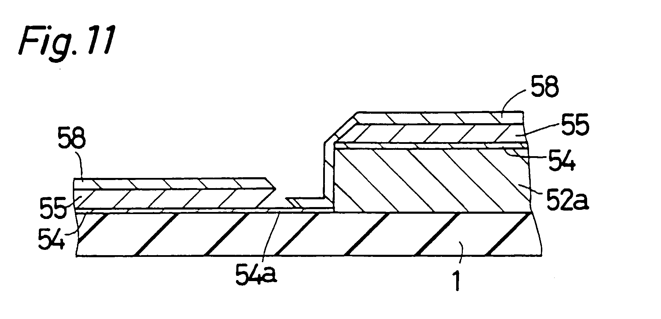

Fig. 7 is a graph showing an experimental result obtained by the inventors. A line 25 in Fig. 7 represents the characteristics of the SQUID shown in Figs 4 and 5. A line 26 represents the characteristics of another embodiment of the invention in which the covering layer 19 is omitted, and a Josephson junction 14a is formed on a layer 11. A line 27 represents the characteristics of a SQUID for comparison, in which a Josephson junction 54 is formed directly on a substrate 1 shown in Fig. 11, and layers 11, 19 are omitted. It is generally preferable that the critical current I1 ranges from 10 to 120 µA. In order to attain such a relatively small critical current I1, as represented by the lines 25, 26, it will be understood that the rate of change in the critical current I1 is small even if the thickness d12 of the Josephson junction 14a varies greatly in a construction made according to the invention. Therefore, according to the invention, it is possible to easily control the critical current I1 of the SQUID so as to make it smaller.

Eventually the covering layer 19 may be omitted from the construction.

According to another experiment conducted by the inventors, when the layers 11, 19 consist of Ta and Cr, the first, second and third layers 14, 15, 18 consist of Nb of purity of 99.9%, the thickness d10, d15 of the layers 11, 19 is set to 100 Å, the thickness of the first layer 14 on which the Josephson junction 14a is formed is set to 100 Å, and the angles θ11, θ12 are selected to be between 25 and 50 degrees, it is confirmed that a defect rate at the time of production of the SQUID which can obtain a preferable critical current I1 of 10 to 100 µA is improved more than that of devices in which the layers 11, 19 as described above are not provided. When the critical current I1 is 100 µA, the output voltage thereof is about 10 µV.

When the thickness d10, d11, d15 of the layers 11, 14, 19 is set to 200 Å with other conditions being equal to the foregoing ones, it is also confirmed that the defect rate is maintained at a preferable level. At this time, the critical current I1 is 120 µA, and the output voltage is 9µV.

### (Embodiment 3)

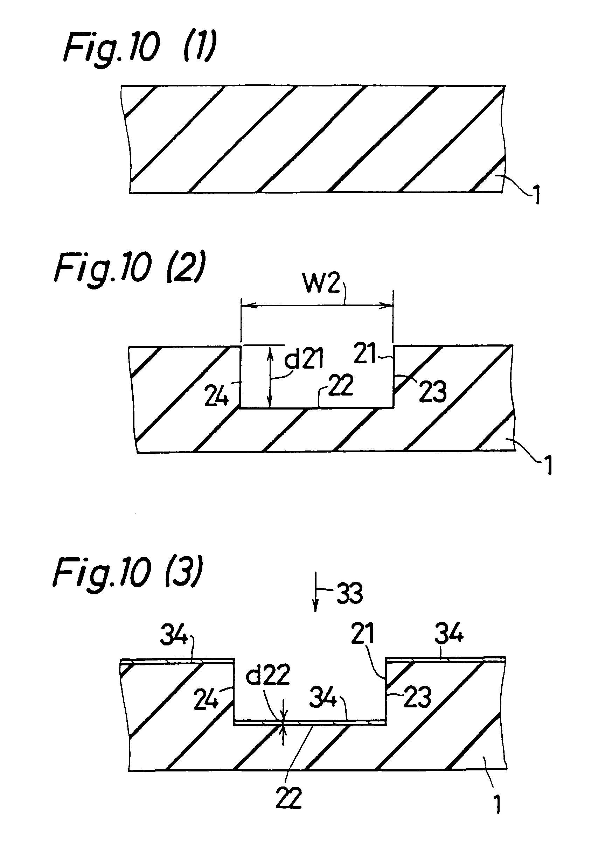

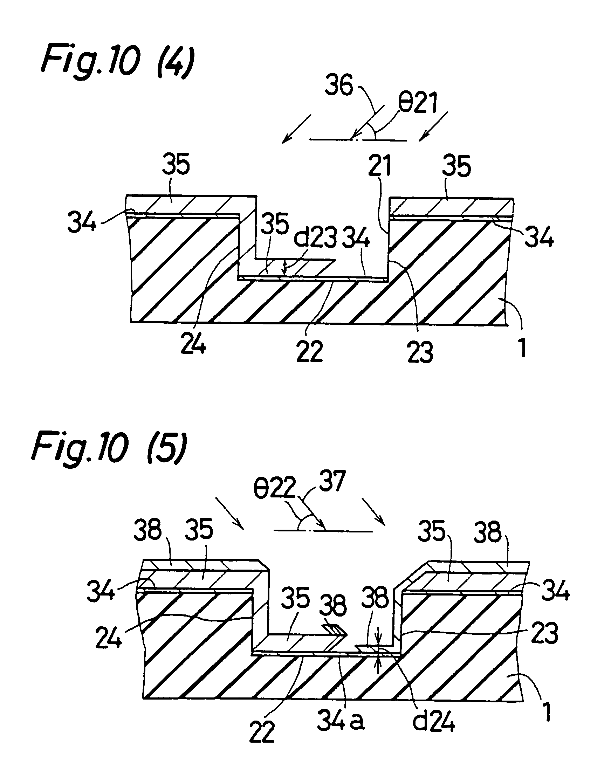

Fig. 9 is a sectional view partially showing a superconductive quantum interference device of still another embodiment made in accordance with the invention, and Figs. 10(1) to 10(5) are sectional views showing the production process according to the invention of the superconductive quantum interference device. A substrate 1 consists of quartz, sapphire, and semiconducting material such as Si, similarly to the substrate 1 shown in the first embodiment. Such substrate 1 is prepared as shown in Fig. 10(1).

Subsequently, a recessed channel 21 is formed in the substrate 1 as shown in Fig. 10(2). The recessed channel 21 has a bottom 22 and opposite side walls 23, 24. The side walls 23, 24 of the recessed channel 21 are positioned perpendicular to the bottom 22. The recessed channel 21 may be, for example, formed by the use of a dry etching technique. The depth d21 of the channel 32 is, for example, 4000 to 5000 Å, the width W2 thereof is, for example, 1 µm, and the length L3 thereof in a direction vertical to the plane of the drawing in Fig. 10(2) may be, for example, 1 to 5 µm similarly to the lengths L1, L2 of the first and second embodiments.

The dry etching technique may be, for example, the spatter technique by which a resist layer having a hole corresponding to the channel 21 is formed on the surface of the substrate 1, and argon ions Ar+ are rendered to crash in a plasma atmosphere.

Thereafter, as shown in Fig. 10(3), superconducting material such as Nb is deposited on the recessed channel 21 from above as indicated by an arrow 33, i.e., a direction perpendicular to the bottom 22 of the channel 21, whereby forming a first layer 34. The first layer 34 is also formed on the surface of the substrate 1 besides the surface of the recessed channel 21. The thickness d22 of the first layer 34 is 80 to 200 Å, preferably 80 to 150 Å, and more preferably 100 A. The superconducting material Nb is deposited on the first layer 34 from an arrow direction 36, whereby forming a second layer 35 as shown in Fig. 10(4). The deposition of the superconducting material Nb from the arrow direction 36 is interrupted by one side wall 23, and therefore the second layer 35 is formed on a part of the first layer 34 on the bottom 22 of the recessed channel 21. The angle θ21 made by the arrow direction 36 with respect to the surface of the bottom 22 is, for example, between 25 and 70 degrees, and preferably between 25 and 50 degrees. The thickness d23 of the second layer 35 is, for example, 1000 Å.

Thereafter, as shown in Fig. 10(5), a superconducting material Nb is deposited on the surface of the first layer 34 from an arrow direction 37 so as to form a third layer 38. In this case, the deposition is interrupted by the other side wall 24, whereby the third layer 38 is formed on another part of the first layer 34 on the bottom 22 where the second layer 35 is not formed. The thickness d24 of the third layer 38 is, for example, 500 Å, and the sum of the thickness d23 and d24 is selected to be, for example 200 to 2000 Å. The angle θ22 made by the arrow direction 37 with respect to the surface of the bottom 22 is between 25 and 70 degrees, and preferably between 25 and 50 degrees. In this way, on the first layer 34 is formed a thin film region 34a; a partially exposed region formed by the second and third layers 35, 38, and thereby a Josephson junction can be obtained. In this manner, an oblique deposition is conducted from opposite sides of the recessed channel 21 as indicated by the arrow directions 36, 37 by using the opposite side walls 23, 24 of the recessed channel 21, whereby the thin film region 34a serving as a Josephson junction is formed. By changing the deposition angles θ21, θ22, the depth d21 of the recessed channel 21, and the thickness d23, d24 of the second and third layers 35, 38, the shape and characteristics of the Josephson junction can be freely controlled.

This production process can be carried out entirely in the same vacuum, which in turn prevents any surface of the substrate 1 including the recessed channel 21 from being stained. Therefore, the production is easier and more convenient.

According to a further experiment conducted by the inventors, when a recessed portion 21 having a depth d21 of 4000 Å was formed on a Si substrate 1, Nb was used as superconducting material, and a superconductive quantum interference device was produced with setting the thickness d22, d23, d24 of the first, second, and third layers 34, 35, 38 to 100 Å, 1000 Å, 500 Å respectively, and deposition angles θ21, θ22 between 30 and 70 degrees, the critical current was 10 µA and the output voltage thereof was 10 µV, whereupon appropriate characteristics could be obtained.

Further, when the thickness d22 of the first layer 34 was set to 200 Å with other conditions being equal to the foregoing ones, the critical current was 18 µA and the output voltage thereof was 7 µV, whereupon appropriate characteristics could be obtained again.

It will be understood that with the process of the invention not only a superconductive quantum interference device, but also other Josephson devices can be made.

## Claims

1. A method of producing a superconductive device of the type with a Josephson junction, comprising the steps of forming a surface step (2a, 12a, 21) on or in a substrate (1), forming a first thin film layer (4, 14, 34) of superconducting material on said substrate (1) and said step (2a, 12a, 21) and subsequently forming a second thin film layer (5, 15, 35) of a superconducting material on said first thin film layer (4, 14, 34) by means of an oblique deposition technique from one side of said surface step so that the deposition is locally interrupted by said surface step and depositing a third thin film layer (8, 18, 38) of a superconducting material by means of an oblique deposition technique from the opposite side of said surface step so as to form a partially exposed region (4a, 14a, 34a) of said first thin film layer (4, 14, 34) not covered by said second and third thin film layers (5, 15, 35; 8, 18, 38) near said step (2a, 12a, 21), said partially exposed region (4a, 14a, 34a) defining said Josephson junction, if desired followed by forming a covering layer (9, 19) of ordinary conducting material over the partially exposed region (4a, 14a, 34a) and a neighbouring region thereof.

2. The method according to claim 1, characterized in that a layer (11) of ordinary conducting material is formed on said substrate (1) before said step (12a) is formed on said substrate (1).

## Patentansprüche

1. Verfahren zur Herstellung einer supraleitfähigen Anordnung mit Josephson-Kontakt mit folgenden Schritten:
Bilden einer Oberflächenstufe (2a, 12a, 21) auf oder in einem Substrat (1),
Bilden einer ersten Dünnschichtebene (4, 14, 34) aus supraleitendem Material auf dem Substrat (1) sowie der Oberflächenstufe (2a, 12a, 21) mit anschließendem Bilden einer zweiten Dünnschichtebene (5, 15, 35) aus supraleitendem Material auf der ersten Dünnschichtebene (4, 14, 34) mittels eines Schrägablagerungsverfahrens von einer Seite der Oberflächenstufe, so daß die Ablagerung örtlich durch die Oberflächenstufe unterbrochen wird, und
Ablagern einer dritten Dünnschichtebene (8, 18, 38) aus supraleitendem Material mittels eines Schrägablagerungsverfahrens von der gegenüberliegenden Seite der Oberflächenstufe, so daß ein teilweise freiliegender Bereich (4a, 14a, 34a) der ersten Dünnschichtebene (4, 14, 34) entsteht, der in der Nähe der Stufe (2a, 12a, 21) von der zweiten und der dritten Dünnschichtebene (5, 15, 35, 8, 18, 38) nicht bedeckt ist, wobei der teilweise freiliegende Bereich (4a, 14a, 34a) den Josephson-Kontakt definiert und sofern gewünscht sich eine Ausbildung einer Deckschicht (9, 19) aus üblichem leitendem Material über dem teilweise freiliegenden Bereich (4a, 14a, 34a) und einem benachbarten Bereich anschließt.

2. Verfahren nach Anspruch 1, dadurch gekennzeichnet, daß eine Schicht (11) eines üblichen leitenden Materials auf dem Substrat (1) vor der Ausbildung der Stufe (12a) auf dem Substrat (1) gebildet wird.

## Revendications

1. Procédé de production d'un dispositif supraconducteur du type à jonction Josephson, comprenant les étapes de formation d'une marche de surface (2a, 12a, 21) sur ou dans un substrat (1), formation d'une première couche mince (4, 14, 34) de matière supraconductrice sur le substrat (1) et la marche (2a, 12a, 21) et ensuite formation d'une deuxième couche mince (5, 15, 35) d'une matière supraconductrice sur la première couche mince (4, 14, 34) par dépôt oblique depuis un côté de la marche de surface de façon que le dépôt soit interrompu localement par celle-ci, et formation d'une troisième couche mince (8, 18, 38) d'une matière supraconductrice par dépôt oblique depuis le côté opposé de la marche de surface de façon à former une zone partiellement exposée (4a, 14a, 34a) de la première couche mince (4, 14, 34) non couverte par les deuxième et troisième couches minces (5, 15, 35 ; 8, 18, 38) près de la marche (2a, 12a, 21), cette zone partiellement exposée (4a, 14a, 34a) formant la jonction Josephson, et ensuite, au besoin, formation d'une couche de couverture (9, 19) en matière conductrice ordinaire sur la zone partiellement exposée (4a, 14a, 34a) et sur une zone voisine de celle-ci.

2. Procédé selon la revendication 1, caractérisé par le fait qu'une couche (11) de matière conductrice ordinaire est formée sur le substrat (1) avant la formation de la marche (12a) sur celui-ci.
